# FASCICULE DE BREVET EUROPEEN

(11) **EP 0 296 989 B1**
(45) Date de publication et mention de la délivrance du brevet: **03.09.1997**
(21) Numéro de dépôt: 88420178.1
(22) Date de dépôt: 02.06.1988
(51) Int. Cl.: H03C 3/09, H04N 5/92

(54) **Dispositif de réglage des fréquences minimale et maximale d'un signal vidéo modulé en fréquence**
Einrichtung zur Steuerung der minimalen und maximalen Frequenzen eines frequenzmodulierten Videosignals
Device for adjusting the minimal and maximal frequencies of a frequency modulated video signal

(30) Priorité: 05.06.1987 FR 8707942
(43) Date de publication de la demande: 28.12.1988
(73) Titulaire: SGS-THOMSON MICROELECTRONICS S.A., 94250 Gentilly (FR)
(72) Inventeur: Douziech, Patrick, D-7730 VS Villingen (DE); Berger, Philippe, D-7730 VS Villingen (DE)
(74) Mandataire: de Beaumont, Michel

(56) Documents cités:
- EP-A- 0 122 095
- GB-A- 782 878
- GB-A- 2 019 145

## Description

L'invention concerne un dispositif de réglage des fréquences fₘᵢₙ et fₘₐₓ d'un signal vidéo modulé en fréquence.

Le document GB-A-782 878 donne un exemple d'un dispositif de calibration de la fréquence d'un oscillateur.

L'invention concerne plus particulièrement le signal de luminance modulé en fréquence dans les magnétoscopes du type VHS, ou 8mm avant l'enregistrement de ce signal sur bande magnétique.

Par exemple en VHS la modulation de fréquence du signal de luminance a pour fréquence minimum une fréquence de 3,8 MHz qui correspond au fond de top de synchronisation et pour fréquence maximum une fréquence de 4,8 MHz qui correspond au blanc maximum. Ces deux fréquences fₘᵢₙ et fₘₐₓ ont pour tolérance 100 kHz de même que leur différence a également pour tolérance 100 kHz, ces tolérances étant imposées par les standards PAL et SECAM en VHS.

Il est usuel d'effectuer un réglage de ces fréquences en usine avant la mise en vente du matériel. Le réglage est fait une fois pour toutes, manuellement, à partir de deux potentiomètres. Pour cela un premier potentiomètre est relié à l'entrée de réglage du gain d'un amplificateur qui reçoit des circuits amont le signal de luminance, et un deuxième potentiomètre est relié à une entrée d'un additionneur qui reçoit sur une autre entrée le signal de sortie de l'amplificateur à gain variable, le signal de sortie de cet additionneur étant appliqué à l'entrée d'un oscillateur commandé en tension qui permet de moduler en fréquence le signal de luminance. Le réglage pour la fréquence fₘₐₓ se fait à partir d'un signal vidéo correspondant au niveau du blanc, ce signal étant injecté à une entrée de l'amplificateur qui reçoit sur une autre entrée un niveau de tension correspondant au fond de top de synchronisation qui détermine la fréquence fₘᵢₙ de démodulation. Le réglage par le premier potentiomètre permet d'augmenter ou de diminuer le gain sur la différence des niveaux d'entrée. Le réglage pour la fréquence fₘᵢₙ se fait à l'aide du deuxième potentiomètre qui réajuste le niveau de tension reçu à une entrée par l'additionneur de manière à obtenir la fréquence fₘᵢₙ désirée.

Les réglages réalisés par cette technique sont à la fois fastidieux et imprécis. De plus, il n'ont lieu qu'une seule fois et à partir d'un signal vidéo spécifique.

L'invention a pour but de remédier à ces problèmes et propose pour cela un dispositif de réglage automatique des fréquences fₘᵢₙ et fₘₐₓ ce réglage se faisant sur toutes les trames du signal vidéo qui est destiné à être enregistré.

L'invention a donc pour objet un dispositif de réglage des fréquences fₘᵢₙ et fₘₐₓ d'un signal vidéo modulé en fréquence, comportant en série un amplificateur à commande automatique de gain, un circuit de traitement du signal de luminance, un amplificateur à gain variable, un additionneur, un oscillateur commandé en tension, caractérisé en ce qu'il comprend en outre :
- un circuit d'insertion entre l'amplificateur et le circuit de traitement, qui reçoit de l'amplificateur un premier niveau de tension de référence correspondant à la fréquence minimum et un deuxième niveau de tension de référence correspondant à la fréquence maximum, en synchronisation respectivement avec un premier et un deuxième signal de commande ;
- un générateur de fréquence apte à générer au moins deux fréquences de référence fₘᵢₙ et fₘₐₓ en synchronisme avec les signaux de commande;
- un circuit de discrimination qui reçoit à une entrée, en fonction des signaux de commande, soit la fréquence fₘᵢₙ, soit la fréquence fₘₐₓ issue du générateur et à une autre entrée, le signal modulé en fréquence de sortie de l'oscillateur, et qui délivre en sortie deux niveaux de tensions fonction des fréquences d'entrée ;
- un comparateur recevant à chacune de ses entrées un des niveaux de tension de sortie du discriminateur et délivrant un niveau de tension correspondant à l'écart entre les deux niveaux d'entrée ;
- un commutateur relié à la sortie du comparateur et actionné par un troisième et un quatrième signal de commande de manière à ce que le niveau de sortie du comparateur permette soit de commander le réglage du gain de l'amplificateur à gain variable, soit d'alimenter une des entrées de l'additionneur selon que la fréquence de référence à l'entrée du discriminateur est la fréquence minimum ou la fréquence maximum de manière à asservir le signal modulé de sortie de l'oscillateur soit par la fréquence de référence fₘᵢₙ soit par la fréquence de référence fₘₐₓ.

L'invention sera mieux comprise à l'aide de la description détaillée faite à titre d'exemple non limitatif et illustrée par :
- la figure 1 qui représente un schéma de réalisation du dispositif selon l'invention,
- la figure 2 qui représente une variante de réalisation du circuit de discrimitation selon la figure 1,
- la figure 3 qui représente le diagramme des temps des signaux de commande.
- la figure 4 qui représente un exemple de réalisation d'un bloc insertion 2 selon la figure 1.

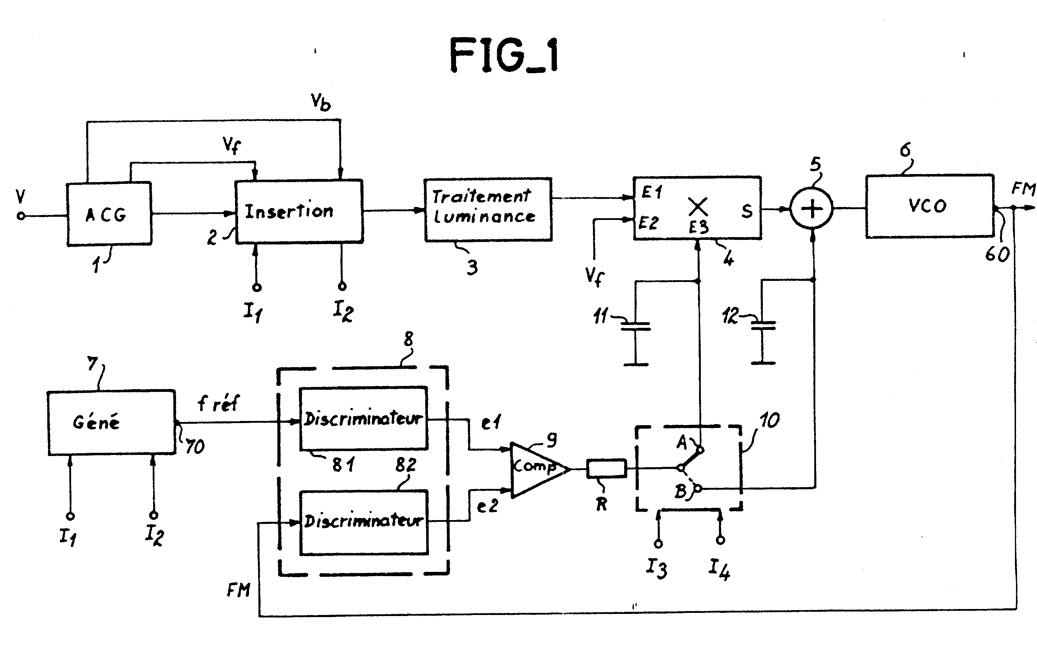

Le signal vidéo V qui n'est constitué à ce stade de traitement que du signal de luminance est appliqué à l'entrée d'un amplificateur à commande automatique de gain 1 représenté sur la figure 1. Un circuit d'insertion 2 reçoit sur une entrée le signal issu de l'amplificateur 1. Le circuit 2 reçoit également sur deux autres entrées les niveaux de tension de référence Vb et Vf obtenus à partir de l'amplificateur 1.

Le niveau Vb correspond au blanc maximum et permet de déterminer la fréquence fₘₐₓ pour la modulation qui sera faite sur le signal de luminance.

Le niveau Vf correspond au fond de top de synchronisation et permet de déterminer la fréquence fₘᵢₙ pour la modulation du signal de luminance. Ce circuit 2 est piloté par deux signaux de commande I1 et I2. Le signal I1 permet d'insérer le niveau correspondant au fond de top lorsque ce signal fond de top est présent sur le signal vidéo V. Le signal 12 permet d'insérer le niveau correspondant au blanc maximum lorsque ce signal est présent sur le signal vidéo V.

Un circuit de traitement 3 du signal de luminance permet d'effectuer une préaccentuation pour les fréquences élevées. Le traitement de préaccentuation sur le signal de luminance est classique en soi et ne sera en conséquence pas plus explicité. Le signal de sortie du circuit 3 est appliqué à une entrée E1 d'un amplificateur à gain variable 4, à entrées différentielles E1, E2. Cet amplificateur 4 reçoit sur l'autre entrée différentielle E2 le niveau de tension Vf. La sortie de l'amplificateur 4 est appliquée à une entrée d'un additionneur 5. L'amplificateur 4 a une troisième E3 entrée pour recevoir un signal de commande de gain. L'additionneur 5 a une deuxième entrée pour recevoir un signal qui va permettre un réglage par réajustage de niveau de la tension qui est appliquée à l'entrée d'un oscillateur 6 commandé en tension. La sortie 60 de l'oscillateur 6 délivre le signal de luminance FM modulé en fréquence.

Un générateur de fréquence de référence 7 est apte à générer des fréquences fₘᵢₙ et f ₘₐₓ de référence ; ces fréquences qui sont disponibles à la sortie 70, vont permettre d'asservir les fréquences fₘᵢₙ et fₘₐₓ du signal vidéo modulé.

Le générateur 7 génère la fréquence fₘᵢₙ sur commande d'un signal I1 qui est également appliqué au circuit d'insertion 2.

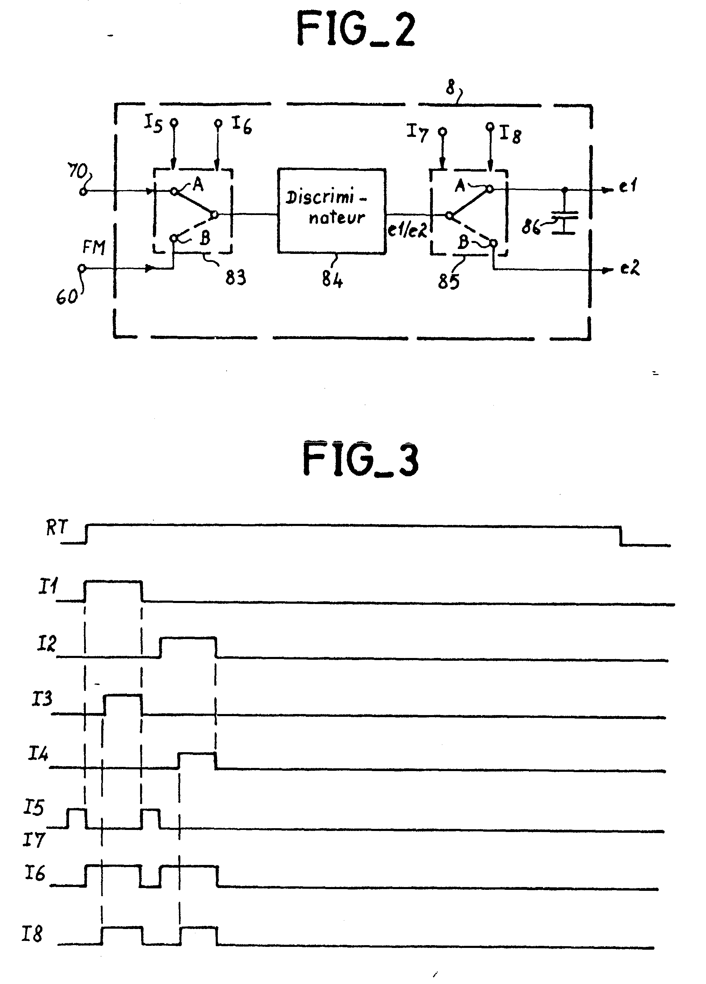

Le signal I1 représenté sur la figure 3 est en synchronisme avec l'impulsion de retour trame RT et permet d'insérer dans le signal vidéo un signal de fond de top qui correspond au niveau de noir, pendant une durée d'une demi ligne pour disposer d'un niveau de noir non bruité pendant cette durée qui est suffisamment longue. Il est donc préférable d'effectuer l'insertion pendant le retour-trame puisque le niveau est présent à ce moment là, pendant une durée plus longue que pendant le retour ligne par exemple.

Le générateur 7 génère la fréquence fₘₐₓ sur commande d'un signal I2 qui est également appliqué au circuit d'insertion 2. Le signal I2 représenté sur la figure 3 correspond à une impulsion d'une durée égale à une ligne et qui déclenche après l'impulsion du signal I1, la réinsertion du niveau de blanc dans le signal vidéo pendant le retour-trame.

Un circuit de discrimination 8 reçoit sur une entrée la fréquence de référence f réf générée et sur une autre entrée le signal modulé en fréquence FM de sortie de l'oscillateur 6.

Le circuit discriminateur délivre deux niveaux de tension e1 et e2 à ses sorties dont un est fonction de la fréquence de sortie de l'oscillateur 6 et l'autre de la fréquence de référence entrée.

Ces deux niveaux e1 et e2 sont appliqués chacun à une entrées d'un amplificateur différentiel 9 qui délivre un niveau de tension égal à la différence des niveaux d'entrée. La sortie du comparateur 9 est reliée à un commutateur 10 par l'intermédiaire d'une résistance R.

Lorsque la fréquence de référence générée est la référence pour fₘₐₓ, la tension de sortie de l'amplificateur 9 est appliquée par l'intermédiaire du commutateur 10 à une borne d'un condensateur 11 l'autre borne étant reliée à une masse électrique. Le condensateur 11 se charge lorsque l'actionneur du commutateur est commuté sur la position A, cette position étant déclenchée par un signal I4 représenté sur la figure 3.

Lorsque la fréquence de référence générée est la référence pour fₘᵢₙ, la tension de sortie de l'amplificateur 9 est appliquée par l'intermédiaire du commutateur 10 à une borne d'un condensateur 12, l'autre borne étant reliée à une masse électrique. Le condensateur 12 se charge lorsque l'actionneur du commutateur est commuté sur la position B, cette position étant déclenchée par le signal I3 représenté sur la figure 3.

Pendant l'insertion du fond de top, le niveau de sortie du comparateur 9 représente l'écart de fréquence entre la fréquence de référence fₘᵢₙ générée et appliquée à l'entrée du discriminateur et la fréquence de modulation. Cet écart de tension permet de charger ou de décharger le condensateur 12. Cet écart de tension modifie la charge de la capacité par l'intermédiaire de la résistance R avec une constante de temps courte, ce qui permet de modifier la fréquence de sortie de l'oscillateur 6 jusqu'à l'obtention de l'égalité entre les tensions e1 et e2.

Pendant l'insertion de blanc maximum le niveau de sortie de l'amplificateur 9 représente l'écart de fréquence entre la fréquence de référence générée fₘₐₓ et appliquée à l'entrée du discriminateur et la fréquence fₘₐₓ de modulation. Cet écart de tension permet de charger ou de décharger le condensateur 11. Cet écart de tension modifie la charge de la capacité avec une constante de temps courte et donc la fréquence de sortie de l'oscillateur 6, jusqu'a assurer l'égalité entre e1 et e2.

Les capacités 11 et 12 servent de mémoire entre deux mesures de fréquences. Le temps entre deux mesures est au minimum égal à 40ms (durée de deux trames). La constante de temps de décharge doit donc être longue pour éviter les variations de fréquences entre deux mesures. La décharge des capacités 11 et 12 est très lente et s'effectue par le courant d'entrée de l'étage de commande de gain du multiplieur pour la capacité 11 et par le courant d'entrée du sommateur pour la capacité 12. Les courants sont des courants de bases de transistors, ayant un courant collecteur Ic égal à 10µA et un gain B de 125 soit un courant de base Ib égal à 80nA.

C'est pour obtenir une indépendance entre les deux boucles d'asservissement, que l'on injecte le niveau de tension Vf de fond de top à la deuxième entrée de l'amplificateur 4 qui est préférentiellement réalisé par un multiplieur à entrées différentielles. Ainsi le multiplieur agit sur la différence des tensions V et Vf soit V - Vf ce qui permet d'obtenir une convergence de réglage entre le réglage obtenu par le multiplieur et l'additionneur.

Sur la figure 2, on a représenté une variante de réalisation du circuit de discrimination 8. Selon cette variante, le circuit ne comporte qu'un seul discriminateur 84 pour obtenir les deux niveaux de tension e1 et e2. En fait ce discriminateur 84 permet au moyen d'un commutateur 83 de recevoir alternativement, soit une fréquence de référence, soit l'autre fréquence de référence, soit le signal modulé en fréquence. Pour cela, une borne A du commutateur 83 est connectée à la borne 70 et l'autre borne B est connectée à la borne 60 tandis que l'actionneur est relié à l'entrée du discriminateur 84. La sortie du discriminateur 84 permet à travers un commutateur 85 de délivrer successivement un niveau de tension e1 pour une fréquence de référence ( fₘᵢₙ par exemple) qui charge un condensateur 86 en attendant que le niveau de tension e2, correspondant au signal FM modulé en fréquence, soit disponible, de manière à appliquer le niveau e1 à une entrée de l'amplificateur 9 et le niveau e2 à l'autre entrée de l'amplificateur 9 qui est représenté sur la figure 1. Une borne A du commutateur 85 est reliée à une entrée de l'amplificateur 9, l'autre borne B est connectée à l'autre entrée de l'amplificateur, l'actionneur étant relié à la sortie du discriminateur.

Les signaux I5, I6 permettent de placer le commutateur 83 respectivement sur les positions A et B, et les signaux I7 et I8 permettent de placer le communateur 85 respectivement sur les positions A et B. Avant que le signal I1 ne soit appliqué pour commander la réinsertion du fond de top, une impulsion du signal I5 permet de placer le commutateur 83 en position A, et en synchronisme, une impulsion du signal I7 permet de placer le commutateur 85 en position A. Lorsque ces deux commutateurs sont en position A le condensateur 86 est chargé par la tension de sortie e1 du discriminateur 84, correspondant à une des fréquences de référence fₘᵢₙ ou fₘₐₓ. Pendant la phase de réinsertion de fond de top, une impulsion du signal I6 permet de placer le commutateur 83 sur la position B et une impulsion du signal I8 permet de placer le commutateur 85 sur la position B également, le niveau de tension e1 qui correspond à la fréquence fₘᵢₙ et e2 qui correspond au signal modulé, vont permettre alors d'agir sur l'additionneur 5 par l'intermédiaire de l'amplificateur 9 et du commutateur 10 qui sont représentés sur la figure 1.

Avant la phase de réinsertion du niveau de blanc, soit avant l'impulsion du signal I2 des deuxièmes impulsions des signaux I5 et I8 permettent de placer les commutateurs 83 et 85 sur la position A de sorte qu'un nouveau niveau de tension e1, correspondant à l'autre fréquence de référence soit fₘₐₓ, permet de charger le condensateur 86.

Pendant la phase de réinsertion du blanc maximum soit pendant l'impulsion du signal I2, une deuxième impulsion du signal I6 permet de placer le commutateur 83 en position B et une deuxième impulsion du signal I8 permet de placer le commutateur 85 en position B. Le niveau de tension e1 qui correspond à la fréquence fₘₐₓ et e2 qui correspond au signal modulé, vont permettre alors d'agir sur le multiplieur 4 par l'intermédiaire de l'amplificateur 9 et du commutateur 10 qui sont représentés sur la figure 1. La capacité 86 ne doit mémoriser une information que pendant une ligne, sa valeur est approximativement de 50pF ce qui la rend parfaitement intégrable.

Les impulsions du signal I8 sont de préférence retardées par rapport aux impulsions du signal I6, tout comme les signaux I3 et I4 par rapport aux signaux I1 et I2 pour tenir compte du retard introduit dans le discriminateur 84 (ou les discriminateurs 81 et 82).

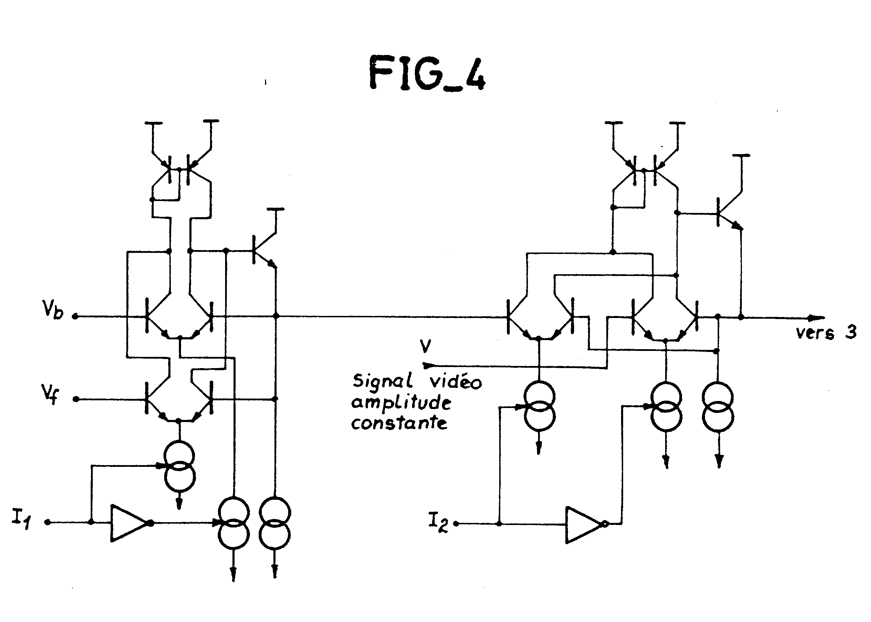

Sur la figure 4, on a représenté à titre tout à fait indicatif un exemple de réalisation classique d'un circuit d'insertion 2, qui permet d'insérer les niveaux Vf et Vb.

## Revendications

1. Dispositif de réglage automatique des fréquences fₘᵢₙ et fₘₐₓ d'un signal vidéo modulé en fréquence, comportant en série un amplificateur à commande automatique de gain (1), un circuit de traitement du signal de luminance (3), un amplificateur à gain variable (4), un additionneur (5), un oscillateur commandé en tension (6), caractérisé en ce qu'il comprend en outre :
- un circuit d'insertion (2) entre l'amplificateur (1) et le circuit de traitement (3), qui reçoit de l'amplificateur un premier niveau de tension de référence (Vf) correspondant à la fréquence minimum fₘᵢₙ et un deuxième niveau de tension de référence (Vb) correspondant à la fréquence maximum fₘₐₓ, en synchronisation respectivement avec un premier (I1) et un deuxième (I2) signal de commande ;
- un générateur de fréquence (7) apte à générer au moins deux fréquences de référence fₘᵢₙ et fₘₐₓ en synchronisme avec les signaux de commande (I1), (I2) ;
- un circuit de discrimination (8) qui reçoit à une entrée, en fonction des signaux de commande, soit la fréquence fₘᵢₙ, soit la fréquence fₘₐₓ issues du générateur (7) et à une autre entrée le signal (FM) modulé en fréquence de sortie de l'oscillateur (6), et qui délivre en sortie deux niveaux de tensions (e1, e2) fonction des fréquences d'entrée ;
- un comparateur (9) recevant à chacune de ses entrées un des niveaux de tension de sortie du discriminateur (8) et délivrant un niveau de tension correspondant à l'écart entre les deux niveaux d'entrée ;
- un commutateur (10) relié à la sortie du comparateur (9) et actionné par un troisième et un quatrième signal de commande (I3, et I4) de manière à ce que le niveau de sortie du comparateur permette soit de commander le réglage du gain de l'amplificateur à gain variable, soit d'alimenter une des entrées de l'additionneur selon que la fréquence de référence à l'entrée du discriminateur est la fréquence minimum ou la fréquence maximum de manière à asservir le signal modulé de sortie de l'oscillateur soit par la fréquence de référence fₘᵢₙ, soit par la fréquence de référence f ₘₐₓ.

2. Dispositif selon la revendication 1, caractérisé en ce que le circuit de discrimination (8) comporte un premier (81) discriminateur recevant les fréquences de référence générées par le générateur (7) et délivrant un premier et un deuxième niveau de tension ; un deuxième discriminateur (82) recevant le signal modulé en fréquence issu de l'oscillateur (6) et délivrant un troisième niveau de tension.

3. Dispositif selon la revendication 1 caractérisé en ce que le circuit de discrimination (8) comporte :
- un premier commutateur (83) dont une première borne (A) est reliée à la sortie (70) du générateur (7) dont une deuxième borne (B) est reliée à la sortie (60) de l'oscillateur (6) ;
- un discriminateur (84) dont l'entrée est reliée à l'actionneur du commutateur (83) de discriminateur (83) recevant soit une fréquence de référence (fₘᵢₙ), soit l'autre fréquence de référence (fₘₐₓ), soit le signal modulé (FM) selon la position de l'actionneur qui est commandée par un cinquième (I5) et un sixième (I6) signal de commande ;
- un deuxième commutateur (85) dont l'actionneur est relié à la sortie du discriminateur, dont une borne (A) est reliée à une entrée du comparateur (9) et dont l'autre borne est reliée à la deuxième entrée du comparateur ; et
- un condensateur (86) dont une borne est reliée à une borne du deuxième commutateur (86), l'autre borne étant reliée à une masse.

4. Dispositif selon l'une quelconque des revendications 1 à 3, caractérisé en ce qu'il comporte en outre un premier condensateur (11) dont une borne est reliée à l'entrée de commande de gain de l'amplificateur à gain variable (4), cette entrée étant également reliée à une borne (A) du commutateur (10) placé en sortie de l'amplificateur (9), et dont l'autre borne est reliée à une masse ; et un deuxième condensateur (12) dont une borne est reliée à une masse et dont l'autre borne est reliée à la deuxième entrée de l'additionneur (5), cette entrée étant reliée à la deuxième borne (B) de ce commutateur (10).

5. Dispositif selon l'une quelconque des revendications 1 à 4, caractérisé en ce que l'amplificateur à gain variable (4) est constitué par un multiplieur à entrées différentielles recevant à une première entrée différentielle le signal de sortie du circuit de traitement (3) et le signal de fond de top à une deuxième entrée différentielle.

## Patentansprüche

1. Vorrichtung zur automatischen Regelung bzw. Einstellung der Frequenzen fₘᵢₙ und fₘₐₓ eines frequenzmodulierten Videosignals, welche in Reihe einen Verstärker mit automatischer Verstärkungsregelung (1), eine Schaltung zur Bearbeitung des Helligkeits- bzw. Luminanzsignals (3), einen Verstärker mit variabler Verstärkung (Regelverstärker) (4), eine Addiervorrichtung (5) und einen spannungsgesteuerten Oszillator (6) aufweist,
dadurch gekennzeichnet, daß sie des weiteren umfaßt:
- eine zwischen dem Verstärker (1) und der Helligkeitssignalbearbeitungsschaltung (3) angeordnete Einfügungs- bzw. Insertionsschaltung (2), welche von dem Verstärker einen der Minimumfrequenz fₘᵢₙ entsprechenden ersten Bezugsspannungspegel (Vf) und einen der Maximumfrequenz fₘₐₓ entsprechenden zweiten Bezugsspannungspegel (Vb) zugeführt erhält, jeweils in Synchronisation mit einem ersten (I1) und einem zweiten (I2) Steuersignal;
- einen zur Erzeugung von wenigstens zwei mit den Steuersignalen (I1), (I2) synchronisierten Bezugsfrequenzen fₘᵢₙ und fₘₐₓ geeigneten Frequenzgenerator (7);
- eine Diskriminatorschaltung (8), welche an einem Eingang in Abhängigkeit von den Steuersignalen entweder die von dem Generator (7) abgegebene Frequenz fₘᵢₙ oder die Frequenz fₘₐₓ und an einem anderen Eingang das frequenzmodulierte Ausgangssignal des Oszillators (6) zugeführt erhält und die an ihrem Ausgang zwei Spannungspegel (e1, e2) in Abhängigkeit von den Eingangsfrequenzen abgibt;
- einen Komparator (9), der an jedem seiner Eingänge einen der Ausgangsspannungspegel des Diskriminators (8) zugeführt erhält und einen dem Abstand bzw. Unterschied zwischen den beiden Eingangspegeln entsprechenden Spannungspegel abgibt;
- einen Kommutator bzw. Umschalter (10), der mit dem Ausgang des Komparators (9) verbunden und durch ein drittes und ein viertes Steuersignal (I3, I4) betätigt bzw. gesteuert wird, derart, daß der Ausgangspegel des Komparators entweder die Steuerung der Verstärkungsregelung bzw. -einstellung des Regelverstärkers (Verstärkers mit variabler Verstärkung) oder die Beaufschlagung eines der Eingänge der Addiervorrichtung gestattet, je nachdem, ob die Bezugsfrequenz am Eingang des Diskriminators die Minimum- oder die Maximumfrequenz ist, um das modulierte Ausgangssignal des oszillators entweder durch die Bezugsfrequenz fₘᵢₙ oder durch die Bezugsfrequenz fₘₐₓ zu steuern bzw. zu regeln.

2. Vorrichtung nach Anspruch 1,
dadurch gekennzeichnet, daß die Diskriminatorschaltung (8) einen ersten Diskriminator (81), welcher die von dem Generator (7) erzeugten Bezugsfrequenzen zugeführt erhält und einen ersten und einen zweiten Spannungspegel erzeugt; sowie einen zweiten Diskriminator (82) aufweist, der das vom Oszillator (6) kommende frequenzmodulierte Signal zugeführt erhält und einen dritten Spannungspegel abgibt.

3. Vorrichtung nach Anspruch 1,
dadurch gekennzeichnet, daß die Diskriminatorschaltung (8) umfaßt:
- einen ersten Kommutator bzw. Umschalter (83), von dem ein erster Anschluß (A) mit dem Ausgang (70) des Generators (7) verbunden ist, und von dem ein zweiter Anschluß (B) mit dem Ausgang (60) des Oszillators (6) verbunden ist;
- einen Diskriminator (84), dessen Eingang mit dem Schalt- bzw. Betätigungsglied des Kommutators bzw. Umschalters (83) verbunden ist, und der je nach der Stellung des Schalt- bzw. Betätigungsgliedes, die durch ein fünftes (I5) und ein sechstes (I6) Steuersignal gesteuert wird, entweder die eine Bezugsfrequenz (fₘᵢₙ) oder die andere Bezugsfrequenz (Fₘₐₓ) oder das modulierte Signal (FM) zugeführt erhält;
- einen zweiten Kommutator bzw. Umschalter (85), dessen Schalt- bzw. Betätigungsglied mit dem Ausgang des Diskriminators verbunden ist, und dessen einer Anschluß (A) mit einem Eingang des Komparators (9) und dessen anderer Anschluß mit dem zweiten Eingang des Komparators verbunden ist; sowie
- einen Kondensator (86), dessen einer Anschluß mit einem Anschluß des zweiten Kommutators (85) und dessen anderer Anschluß mit Masse verbunden ist.

4. Vorrichtung nach einem der Ansprüche 1 bis 3, dadurch gekennzeichnet, daß sie des weiteren aufweist: einen ersten Kondensator (11), dessen einer Anschluß mit dem Verstärkungssteuer- bzw. -regeleingang des Regelverstärkers (4) verbunden ist, wobei dieser Eingang gleichzeitig mit einem Anschluß (A) des im Ausgang des Verstärkers (9) liegenden Kommutators bzw. Umschalters (10) verbunden ist, und dessen anderer Anschluß an Masse liegt; sowie einen zweiten Kondensator (12), dessen einer Anschluß an Masse liegt und dessen anderer Anschluß mit dem zweiten Eingang der Addiervorrichtung (5) verbunden ist, der mit dem zweiten Anschluß (B) dieses Kommutators bzw. Umschalters (10) verbunden ist.

5. Vorrichtung nach einem der Ansprüche 1 bis 4, dadurch gekennzeichnet, daß der Verstärker mit veränderlicher Verstärkung (Regelverstärker) (4) von einer Multipliziervorrichtung mit differentiellen Eingängen gebildet wird, die an einem ersten Differenzeingang das Ausgangssignal der Signalbearbeitungsschaltung (3) zugeführt erhält, und an einem zweiten Differenzeingang das Austastsignal zugeführt erhält.

## Claims

1. An automatic setting device for frequencies fₘᵢₙ and fₘₐₓ of a frequency modulated video signal, comprising in series an automatic gain control amplifier (1), a processing circuit of the luminance signal (3), a variable gain amplifier (4), an adder (5), a voltage-controlled oscillator (6), characterized in that it further comprises:
- an insertion circuit (2) located between the AGC amplifier (1) and the processing circuit (3), which receives from the amplifier a first reference voltage level (Vf) corresponding to the minimum frequency fₘᵢₙ and a second reference voltage level (Vb) corresponding to the maximum frequency fₘₐₓ, respectively synchronized with a first (I1) and a second (I2) control signal;
- a frequency generator (7) adapted to produce at least two reference frequencies fₘᵢₙ and fₘₐₓ synchronized with the control signals (I1), (I2);
- a discrimination circuit (8) which receives at one input, in relation with the control signals, either the frequency fₘᵢₙ, or the frequency fₘₐₓ from the generator (7) and at another input the frequency modulated signal (FM) of the oscillator output (6), and which provides two voltage levels (e1, e2) in relation with input frequencies;
- a comparator (9) receiving on each of its inputs one of the output voltage levels of the discriminator (8) and providing a voltage level corresponding to the difference between the input levels; and
- a switch (10) connected with the output of comparator (9) and controlled by third and fourth control signals (I3 and I4) in order that the output level of the comparator permits either to control the setting of the gain of the variable gain amplifier, or to feed one of the inputs of the adder depending on whether the reference frequency at the input of the discriminator is the minimum frequency or the maximum frequency in order to servo-control the output modulated signal of the oscillator either by the reference frequency fₘᵢₙ, or by the reference frequency fₘₐₓ·

2. A device according to claim 1, characterized in that the discrimination circuit (8) comprises a first (81) discriminator receiving the frequencies emitted by the generator (7) and providing first and second voltage levels; a second discriminator (82) receiving the frequency modulated signal emitted by oscillator (6) and providing a third voltage level.

3. A device according to claim 1, characterized in that the discrimination circuit (8) comprises:
- a first switch (83), a first terminal (A) of which is connected with the output (70) of the generator (7), and a second terminal (B) of which is connected with the output (70) of the oscillator (6);
- a discriminator (84), the input of which is connected with the actuator of the first switch (83), this discriminator (83) receiving either one reference frequency (fₘᵢₙ), either the other reference frequency (fₘₐₓ), or the modulated signal (FM) according to the position of the actuator which is controlled by fifth (I5) and sixth (I6) control signals;
- a second switch (85), the actuator of which is connected with the output of the discriminator, a terminal (A) of which is connected with one input of the comparator (9), and the other terminal of which is connected with the second input of the comparator; and
- a capacitor (86), a terminal of which is connected with a terminal of the second switch (86), the other terminal being grounded.

4. A device according to any of claims 1 to 3, characterized in that it further comprises a first capacitor (11), a terminal of which is connected with the gain control input of the variable gain amplifier (4), this input being also connected with a terminal (A) of switch (10) located at the output of amplifier (9), and the other terminal of which is grounded; and a second capacitor (12), a terminal of which is grounded and the other terminal of which is connected with the second input of the adder (5), this second input being connected with the second terminal (B) of this switch (10).

5. A device according to any of claims 1 to 4, characterized in that the variable gain amplifier (4) comprises a multiplier with differential inputs receiving at a first differential input the output signal of the processing circuit (3) and the blancking signal at a second differential input.
